# EUROPEAN PATENT APPLICATION

(11) **EP 2 506 293 A1**
(43) Date of publication of application: **03.10.2012**
(21) Application number: 12162087.6
(22) Date of filing: 29.03.2012
(51) Int. Cl.: H01L 21/3105, H01L 21/02

(54) **Method for forming germanium oxide film and material for electronic device**

(30) Priority: 30.03.2011 JP 2011074682
(71) Applicant: TOKYO ELECTRON LIMITED, Minato-ku Tokyo 107-6325 (JP)
(72) Inventor: Kabe, Yoshiro, Yamanashi, 407-0192 (JP); Osaki, Yoshinori, Miyagi, 981-3629 (JP)
(74) Representative: HOFFMANN EITLE

(57) **Abstract**

A method for forming a germanium oxide film between a germanium substrate and an insulating film includes producing atomic oxygen on a surface of the insulating film formed on a surface of the germanium substrate by generating a plasma of a processing gas containing oxygen atom-containing gas. The method further includes forming a germanium oxide film by reacting germanium with the atomic oxygen which has reached the germanium substrate after penetrating the insulating film by irradiating the plasma on the surface of the insulating film.

## Description

### Field of the Invention

The present invention relates to a method for forming a germanium oxide film in the case of manufacturing an electronic device having a high-k insulating film and a germanium substrate, and a material for the electronic device.

### Background of the Invention

Conventionally, silicon has been widely used as a material for an electronic device. Recently, however, a device using a germanium (Ge) substrate instead of a silicon substrate is being developed to realize high mobility of CMOS. Further, a high-k film having a high dielectric constant is widely used due to reduction of an effective oxide thickness (EOT).

Since the interface characteristics of the interface between the High-k film and the Ge substrate are poor, an oxide film, e.g., a GeO₂ film, is provided as an interlayer film to improve interface characteristics. Conventionally, a GeO₂ film is formed on a clean Ge substrate by a thermal oxidation method or the like in one apparatus and, then, a high-k film is formed by a chemical vapor deposition (CVD) method or the like in another apparatus.

However, the GeO₂ film is water-soluble and absorbs moisture when it is exposed to the atmosphere during the time period until the high-k film is formed after the GeO₂ film is formed. Further, in the case of performing heat treatment at about 400°C, GeO is formed at the GeO₂/Ge interface, and GeO₂ is lost. In any case, the interface characteristics or the bulk characteristics deteriorate, and the film thickness is changed.

To that end, there is suggested a technique for preventing deterioration of the GeO₂ film by forming a High-k film or silicon on the GeO₂ film (K. Kita et al., JJAP 47 (2008) 2349). In the case of forming the high-k film in the same apparatus by performing an in-situ process after forming the GeO₂ film by oxidizing the Ge substrate, the GeO₂ film is not exposed to the atmosphere, so that the deterioration can be reduced. However, the configuration of the apparatus becomes complicated and its realization is not practically implementable.

As described above, in a conventional case, the Ge oxide film and the High-k film are formed in different apparatuses. Therefore, the exposure of the Ge oxide film to the atmosphere cannot be avoided, and it is extremely difficult to solve the problems caused by volatilization or moisture absorption.

### Summary of the Invention

In view of the above, the present invention provides a method for forming a good germanium oxide film at an interface between a germanium substrate and an insulating film.

In accordance with an aspect of the present invention, there is provided a method for forming a germanium oxide film between a germanium substrate and an insulating film, including: producing atomic oxygen on a surface of the insulating film formed on a surface of the germanium substrate by generating a plasma of a processing gas containing oxygen atom-containing gas; and forming a germanium oxide film by reacting germanium with the atomic oxygen which has reached the germanium substrate after penetrating the insulating film by irradiating the plasma on the surface of the insulating film.

Therefore, by the plasma of the oxygen gas, the plasma process is performed on the germanium (Ge) substrate on which the insulating film (High-k film) is formed in advance, so that the germanium (Ge) oxide film is formed at the interface between the insulating film and the Ge substrate. Accordingly, interface characteristics between the insulating film and the Ge substrate can be improved. Further, the insulating film functions as a protective film to protect the Ge oxide film, so that deterioration of the Ge oxide film can be prevented, and a good Ge oxide film can be obtained.

Further, the insulating film may be a High-k film.

In accordance with another aspect of the present invention, there is provided a material for an electronic device having a germanium oxide film formed by the method described above.

In accordance with the present invention, since the germanium oxide film is formed on the Ge substrate on which the high-k film is formed in advance, the separation of the unstable germanium oxide film is prevented and good interface characteristics between the high-k film and the germanium substrate can be obtained.

### Brief Description of the Drawings

The objects and features of the present invention will become apparent from the following description of embodiments, given in conjunction with the accompanying drawings, in which:
Fig. 1 is a schematic vertical cross sectional view showing an example of a plasma processing apparatus in accordance with an embodiment of the present invention;
Fig. 2 is a top view showing an example of a slot plate used in the plasma processing apparatus shown in Fig. 1;
Figs. 3A and 3B show a method for oxidizing a Ge substrate in accordance with the embodiment of the present invention, wherein each of Figs. 3A and 3B shows a schematic cross sectional view showing the processes of the method;
Fig. 4 is a graph showing a comparison between oxygen active species and a binding energy between Si and Ge; and
Fig. 5 is a graph showing a test example in accordance with the embodiment of the present invention.

### Detailed Description of the Embodiments

Hereinafter, embodiments of the present invention will be described in detail with reference to the accompanying drawings which form a part hereof.

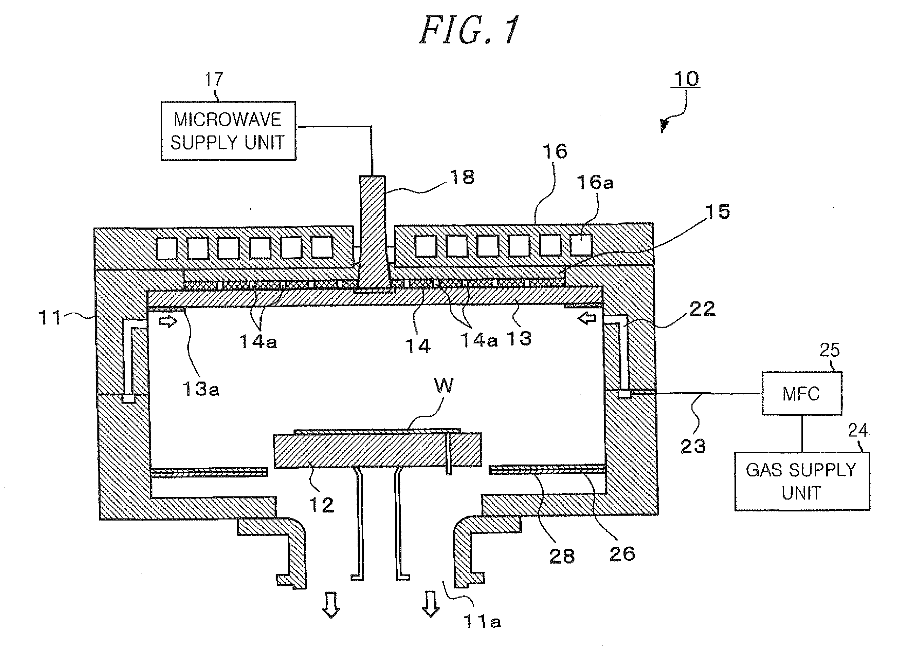

Fig. 1 shows a schematic configuration of a plasma processing apparatus 10 in accordance with an embodiment of the present invention. The plasma processing apparatus 10 includes a processing chamber 11 in which a substrate supporting table 12 for supporting a Ge substrate W as a substrate to be processed is provided, and air (gas) in the processing chamber 11 is exhausted through a gas exhaust port 11a. The substrate supporting table 12 has therein a heater (not shown), so that the substrate W can be heated to a predetermined temperature.

An opening is formed at the top portion of the processing chamber 11 so as to correspond to a substrate W on a substrate supporting table 12. The opening is closed by a microwave transmitting plate 13 made of a dielectric material, e.g., quartz, Al₂O₃ or the like. The microwave transmitting plate 13 is hermetically supported by a supporting member 13a via a sealing member, e.g., an O-ring (not shown) or the like. A slot plate 14 serving as an antenna is provided above (outside) the dielectric microwave transmitting plate 13. The slot plate 14 is formed of a thin circular plate which has a surface plated with gold or silver and is made of a conductive material, e.g., copper, aluminum, nickel or the like. The slot plate 14 has a plurality of slits 14a. The slits 14a are arranged in a concentric circular shape or a substantially spiral shape.

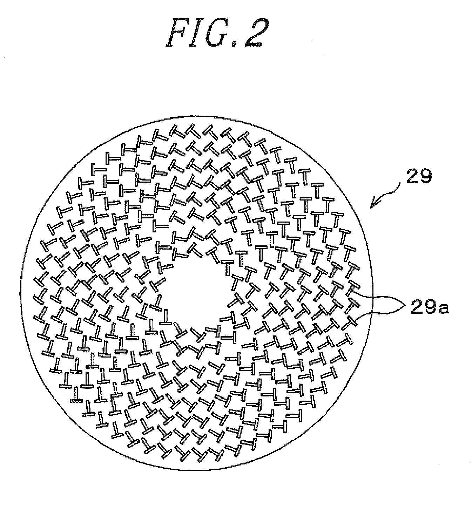

The plasma processing apparatus for performing a plasma oxidation process in accordance with the present embodiment is not necessarily include the slot plate 14 of a SPA (Slot Plane Antenna) type shown in Fig. 1, and may include a slot plate 29 of a RLSA (Radial Line Slot Antenna) type shown in Fig. 2. As shown in Fig. 2, a plurality of slots 29a is formed in a concentric circular shape on the surface of the slot plate 29 of the RLSA. Each of the slots 29a is a substantially rectangular-shaped groove, and the slots adjacent to each other form an alphabet "T" shape while being arranged to intersect each other at a right angle. The length or the arrangement interval of the slots 29a is determined depending on the wavelength of the microwave generated by the microwave supply unit 17.

A dielectric plate 15 made of quartz, alumina, aluminum nitride or the like is provided above the slot plate 14. The dielectric plate 15 serves as a wave retardation plate. A metal plate 16 is provided above the dielectric plate 15. A coolant path 16a through which a coolant flows is formed in the plate 16. A coaxial waveguide 18 for introducing a microwave generated by the microwave supply unit 17 and having a frequency of, e.g., about 2.45 GHz, is provided at an upper central portion of the processing chamber 11.

A gas baffle plate 26 made of, e.g., quartz, is provided to surround the substrate supporting table 12 of the processing chamber 11. The quartz gas baffle plate 26 is supported by a supporting member 28 made of, e.g., aluminum.

A gas nozzle 22 for introducing a gas is provided at an inner wall of the processing chamber 11. A gas supply source 24 is connected to the gas nozzle 22 through a gas line 23. A flow rate of a gas supplied from the gas nozzle is controlled by a mass flow controller (MFC) 25 provided at the gas line 23.

The plasma processing apparatus 10 of the present embodiment is configured as described above. Hereinafter, a method for forming an insulating film on a Ge substrate by using the plasma processing apparatus 10 will be described.

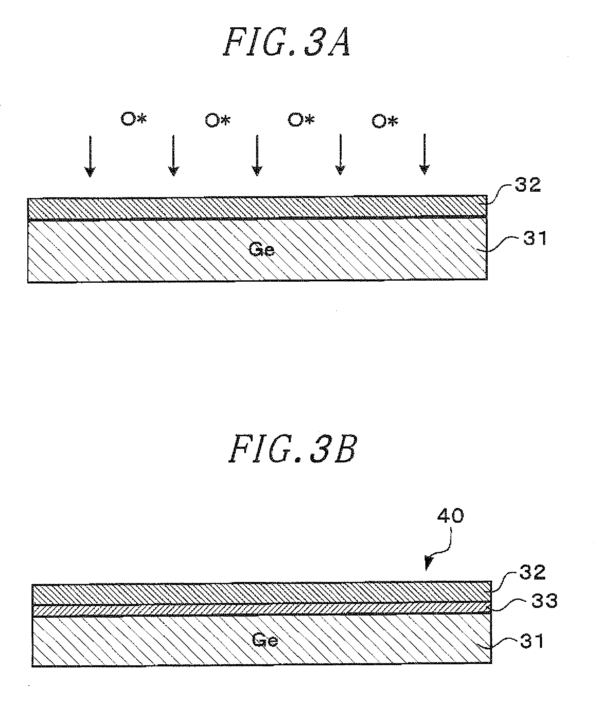

Figs. 3A and 3B show the sequence of processing a Ge substrate by using the plasma processing apparatus 10 shown in Fig. 1.

The high-k material which can be used in the present embodiment is not particularly limited. However, in a practical MOS transistor, it is preferable to use a material having k (relative dielectric constant) higher than or equal to about 8, and it is more preferable to use a material having k higher than or equal to about 10. As for the High-k material, it is preferable to use one or more materials selected from the group consisting of Al₂O₃, ZrO₂, HfO₂, Ta₂O₅, Dr₂O₃, silicate such as ZrSiO, HfSiO or the like, and aluminate such as ZrAlO or the like.

First, a Ge substrate 31 (corresponding to the substrate W) having a High-k film 32 formed thereon is loaded into the processing chamber 11 (see Fig. 1). The film thickness of the High-k film 32 is about 1.5 nm to 4.0 nm. Next, an inner space of the processing chamber 11 is exhausted through an exhaust port 11a by a vacuum pump (not shown), and the pressure in the processing chamber 11 is set to a predetermined pressure of about 10 Pa to 1333 Pa. Preferably, it is set to be higher than or equal to about 133 Pa and lower than or equal to about 1333 Pa. More preferably, it is set to be higher than or equal to about 133 Pa and lower than or equal to about 933 Pa.

Next, O₂ gas is introduced from a gas nozzle 22 together with a nonreactive gas such as Ar, Kr or the like. At this time, the flow rate of the Ar gas is set to be in a range from about 100 ml/min(sccm) to about 2000 ml/min(sccm); and the flow rate of the O₂ gas is set to be in a range from about 5 ml/min(sccm) to about 500 ml/min(sccm). Preferably, the Ar gas flow rate is set to be in a range from about 1000 ml/min(sccm) to about 2000 ml/min(sccm); and the O₂ gas flow rate is set to be in a range from about 10 ml/min(sccm) to about 300 ml/min(sccm).

The temperature of the Ge substrate 31 is set to be in a range from a room temperature to about 500°C. Preferably, the Ge substrate 31 is heated to a temperature in a range from about 100°C to 400°C, e.g., about 300°C.

The microwave is supplied from the microwave supply unit 17 to the slot antenna through the coaxial waveguide 18, and then is introduced into the processing chamber 11. The frequency of the microwave is about a few GHz, and preferably in a range from about 1.9 GHz to about 10 GHz. For example, the frequency of about 2.45 GHz is used. The output of the microwave is preferably in a range from about 0.5 W/cm² to 2.57 W/cm², and more preferably in a range from about 1.0 W/cm² to 2.0 W/cm². For example, in the case of a wafer having a diameter of about 300 mm, the microwave power ranging from about 2000 W to 4000 W is introduced into the processing chamber 11 through the dielectric plate 15, the slot plate 14, and the microwave transmitting plate 13. The oxygen gas in the processing chamber 11 is excited by the high-density microwave plasma formed on the surface of the High-k film 32 on the Ge substrate 31, thereby forming atomic oxygen (oxygen radicals), oxygen ions and the like. By irradiating the high-density microwave plasma, the atomic oxygen O* reaches the surface of the high-k film 32, as shown in Fig. 3A.

The atomic oxygen O* modifies the high-k film 32 from the surface side thereof, and a part of the atomic oxygen O* penetrates the high-k film 32 and reaches the interface between the High-k film 32 and the Ge substrate 31. Accordingly, the atomic oxygen O* reacts with the Ge substrate 31, thereby oxidizing the Ge substrate 31. As a result, a Ge oxide film 33, e.g., a GeO₂ film, having a thickness of, e.g., about 0.5 nm, is formed at the interface between the High-k film 32 and the Ge substrate 31, as shown in Fig. 3B. By performing a plasma oxidation process on the Ge substrate 31 through the High-k film 32, a material for an electronic device 40 having a High-k/GeO₂/Ge structure is formed.

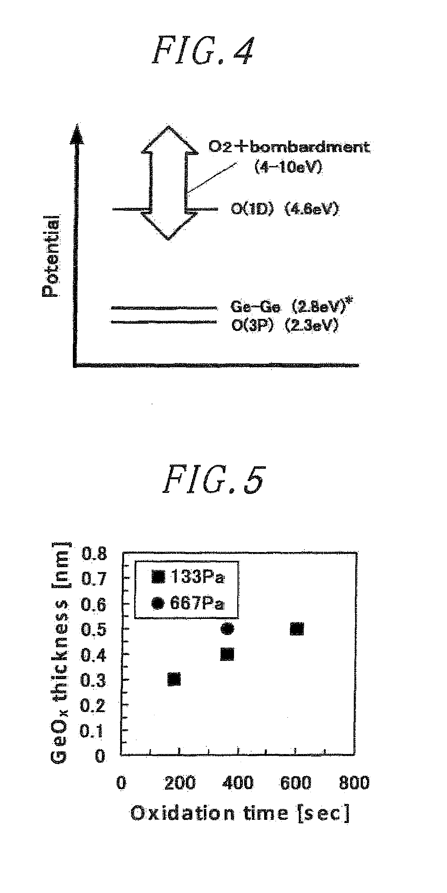

Fig. 4 is a graph showing a comparison between binding energy of germanium and energy of oxygen active species existing in a plasma. As shown in Fig. 4, oxygen active species O(1D) radical and O2+iron have the energy greater than or equal to the binding energy of Ge. Thus, Ge is sufficiently oxidized to form GeO₂ by the O₂+ion and the oxygen active species O(1D) radical generated by the plasma of the oxygen gas. Although the O(3F) in a ground state has the energy lower than that of Ge, the energy difference therebetween is small. Therefore, the O(3P) radical can also react with Ge.

As described above, in the present embodiment, there is provided the Ge substrate 31 on which the high-k film 32 is formed in advance, and the plasma of the processing gas containing an oxygen atom-containing gas is irradiated to the high-k film 32 formed on the Ge substrate 31, thereby forming the Ge oxide film 33 at the interface between the high-k film 32 and the Ge substrate 31. Accordingly, the good interface characteristics between the Ge substrate and the insulating film (interface roughness or the like) can be obtained. Moreover, the High-k film 32 provides the effect of capping GeO₂, so that the unstable Ge oxide film 33 is not exposed to the atmosphere and prevented from absorbing moisture or being volatilized. Hence, the Ge oxide film 33 is properly formed, and the good interface characteristics are obtained. Since a complicated apparatus configuration is not required, the conventional plasma processing apparatus can also be used.

### (Test example)

As for the High-k film, an Al₂O₃ film was used. The High-k film was formed on the Ge substrate first by, e.g., an ALD (Atomic layer deposition) method and, then, the SPA (Slot Plane Antenna) plasma oxidation process was performed through the High-k film. The pressure in the processing chamber was set to have two conditions of a low level of about 133 Pa and a high level of about 667 Pa, and the other processing conditions were the same. In other words, the flow rates of the Ar gas and the O₂ gas were set to about 1980 sccm and 20 seem, respectively. The output power of the microwave was set to about 4000 W, and the temperature of the Ge substrate was set to about 300°C. The result obtained under such conditions is shown in Fig. 5. The film thickness of the Ge oxide film was measured by using the X-ray photoelectron spectroscopy (XPS).

Fig. 5 shows that the film thickness of the Ge oxide film is increased as the processing time is increased. In other words, it was found that the Ge oxide film was formed at the interface between the High-k film and the Ge substrate by the method for forming a Ge oxide film of the present embodiment. Further, it was found that when the processing pressure was set to about 667 Pa higher than about 133 Pa, the film thickness and the film forming speed were increased. In addition, the film thickness of the Al₂O film used as the High-k was preferably in a range from about 1.5 nm to about 4.0 nm, and the film thickness of the Ge oxide film was preferably in a range from about 0.5 nm to about 1.5 nm.

While the invention has been shown and described with respect to the embodiments, it will be understood by those skilled in the art that various changes and modification may be made without departing from the scope of the invention as defined in the following claims.

## Claims

1. A method for forming a germanium oxide film between a germanium substrate and an insulating film, comprising:
producing atomic oxygen on a surface of the insulating film formed on a surface of the germanium substrate by generating a plasma of a processing gas containing oxygen atom-containing gas; and
forming a germanium oxide film by reacting germanium with the atomic oxygen which has reached the germanium substrate after penetrating the insulating film by irradiating the plasma on the surface of the insulating film.

2. The method of claim 1, wherein the insulating film is a High-k film.

3. The method of claim 1 or 2, wherein the processing gas contains a rare gas and an oxygen gas.

4. The method of any one of claims 1 to 3, wherein a pressure at which the plasma is generated is higher than or equal to about 133 Pa and lower than or equal to about 933 Pa.

5. The method of any one of claims 1 to 4, wherein the atomic oxygen is O(1D) radical.

6. A material for an electronic device having a germanium oxide film obtainable by the method described in any one of claims 1 to 5.
